Europäisches Patentamt

European Patent Office

Office européen des brevets

(11) Veröffentlichungsnummer: **0 036 976**
**B1**

(12) **EUROPÄISCHE PATENTSCHRIFT**

(45) Veröffentlichungstag der Patentschrift: **19.12.84**

(51) Int. Cl.³: **G 01 D 18/00, G 01 D 5/34**

(21) Anmeldenummer: **81101786.2**

(22) Anmeldetag: **11.03.81**

(54) **Prüfeinrichtung für ein digitales elektrisches Längen- oder Winkelmessystem.**

(30) Priorität: **20.03.80 DE 3010611**

(43) Veröffentlichungstag der Anmeldung:
**07.10.81 Patentblatt 81/40**

(45) Bekanntmachung des Hinweises auf die
Patenterteilung:
**19.12.84 Patentblatt 84/51**

(84) Benannte Vertragsstaaten:
**AT CH FR GB IT LI NL SE**

(56) Entgegenhaltungen:
**DE-A-2 807 580**
**US-A-3 421 009**
**US-A-3 945 037**

**IBM TECHNICAL DISCLOSURE BULLETIN,
Band 15, Nr. 12, Mai 1973, Seiten 3825, 3826
New York, U.S.A. M.J. BURKE et al.: "Linear
angle encoder"**

(73) Patentinhaber: **Dr. Johannes Heidenhain GmbH
Nansenstrasse 17
D-8225 Traunreut (DE)**

(72) Erfinder: **Schmitt, Walter, Ing. grad
Hochgernstrasse 22
D-8225 Traunreut (DE)**

(56) References cited:
**IBM TECHNICAL DISCLOSURE BULLETIN,
Band 18, Nr. 2, Juli 1975, Seiten 304-305 New
York, U.S.A. J.C. ENGELBRECHT et al.:
"Photocurrent equalization"
"Elektrische Messgeräte und Messverfahren",
Springer-Verlag, Berlin/Heidelberg/New York,
1965, Seiten 239-241, P.M. Pflier - H. Jahn**

EP 0036976 B1

Courier Press, Leamington Spa, England.

## Beschreibung

Die Erfindung betrifft eine digitale Längen- oder Winkelmeßeinrichtung gemäß dem Oberbegriff des Anspruchs 1.

Derartige digitale Längen- oder Winkelmeßeinrichtungen sind aus der Literaturstelle "Elektrische Meßgeräte und Meßverfahren", Springer-Verlag Berlin/Heidelberg/New York, 1965, Seiten 239—241, P. M. Pflier/H. Jahn bereits bekannt.

Die Literaturstelle "IBM Technical Disclosure Bulletin", Band 15, Nr. 12, Mai 1973, Seiten 3825—3826, New York, U.S.A., M. J. Burke et al.: "Linear angle encoder" beschreibt einen linearen Winkelencoder, bei dem eine Photozelle eine Spannung proportional zu ihrer Beleuchtung liefert; diese Spannung wird durch zwei Verstärker zur Erzeugung eines Positionssignals verstärkt. Zur "Offset"-Kalibrierung wird eine lichtemittierende Diode zur Beleuchtung der Photozelle ausgeschaltet, wodurch die Eingangsspannung am ersten Verstärker auf Null reduziert wird. Anschließend wird die Ausgangsspannung des zweiten Verstärkers auf eine definierte Spannung eingestellt, indem ein erster Kondensator mit der Ausgangsspannung eines dritten Verstärkers geladen wird, bis die Ausgangsspannung des zweiten Verstärkers gleich einer Referenzspannung am Eingang des dritten Verstärkers ist. Zur "Gain"-Kalibrierung wird die Leuchtstärke der lichtmittierenden Diode eingestellt, bis die Ausgangsspannung des zweiten Verstärkers mit einer zweiten definierten Spannung übereinstimmt, die einem vierten Verstärker zugeführt wird. Ein zweiter Kondensator, dem eine Treiberstufe für die lichtemittierende Diode nachgeschaltet ist, wird in Abhängigkeit von der Polarität des Ausgangsspannung des zweiten Verstärkers entladen oder geladen, so daß der Diodenstrom fällt oder steigt.

Die Literaturstelle "IBM Technical Disclosure Bulletin", Band 18, Nr. 2, Juli 1975, Seiten 304—305, New York, U.S.A., J. C. Engelbrecht et al.: "Photocurrent equalization" betrifft ein optisches Positionsmeßsystem mit einem Paar von Phototransistoren $T_1$, $T_4$, die von lichtemittierenden Dioden LED1, LED2 beleuchtet werden. Zur Einstellung der Gleichheit der beiden Phototransistoren $T_1$, $T_4$ sind ihre Ausgangssignale VS1, VS2 jeweils über Komperatoren, Und-Glieder, Zähler, D/A-Converter und Verstärker mit Transistoren $T_2$, $T_3$ verbunden, die an die lichtemittierenden Dioden LED1, LED2 angeschlossen sind. Durch schrittweise Erhöhung der Basisströme der Transistoren $T_2$, $T_3$ wird die Leuchtstärke der Dioden LED1, LED2 herabgesetzt, bis die Ausgangssignale VS1, VS2 der Phototransistoren $T_1$, $T_4$ mit Referenzsignalen an den Komparatoren übereinstimmen und die Gleichheit zwischen den Phototransistoren $T_1$, $T_4$ hergestellt ist.

Bei einer digitalen Längen- oder Winkelmeßeinrichtung ist die richtige Einstellung der Triggerschwellen der Triggerstufen unerläßlich, um Fehlmessungen auszuschließen. Die ursprünglich eingestellte Lage der Triggerschwellen kann sich im Laufe der Zeit durch Alterung der elektronischen Bauteile und/oder der Beleuchtungseinrichtung ändern. Bei der zeitaufwendigen Überprüfung dieser Einstellung mittels eines Oszillographen steht das Meßsystem für seine eigentliche Aufgabe nicht zur Verfügung, so daß sich Fehlzeiten in der Anwendung des Meßsystems ergeben.

Der Erfindung liegt die Aufgabe zugrunde, bei einer absoluten oder inkrementalen Längen- oder Winkelmeßeinrichtung auf einfache Weise eine Überprüfung der Einstellung der Triggerschwellen der Triggerstufen anzugeben.

Diese Aufgabe wird erfindungsgemäß durch die kennzeichnenden Merkmale des Anspruchs 1 gelöst.

Die mit der Erfindung erzielten Vorteile bestehen insbesondere darin, daß fehlerhafte Lagen der Triggerschwellen von außen sofort erkannt werden können, ohne in die Meßeinrichtung mit dem entsprechenden Zeitaufwand eingreifen zu müssen. Durch das Vorsehen von verschiedenen Prüfbereichen kann die Tendenz der Änderungen der Lage der Triggerschwellen verfolgt werden, so daß eine erforderliche neue Einstellung rechtzeitig vorgenommen werden kann. Weiterhin kann bei einem derartigen Meßsystem, bei dem als Beleuchtungseinrichtung mehrere lichtemittierenden Dioden vorgesehen sind, die unterschiedlich altern, einer vorzeitigen Helligkeitseinbuße dieser Dioden frühzeitig durch Austausch begegnet werden.

Weitere vorteilhafte Ausbildungen der Erfindung entnimmt man den abhängigen Ansprüchen.

Ausführungsbeispiele der Erfindung werden anhand der Zeichnung näher erläutet.

Es zeigen

Figur 1 schematisch ein absolutes Winkelmeßsystem und

Figur 2—3 Schaltungsanordnungen nach der Erfindung.

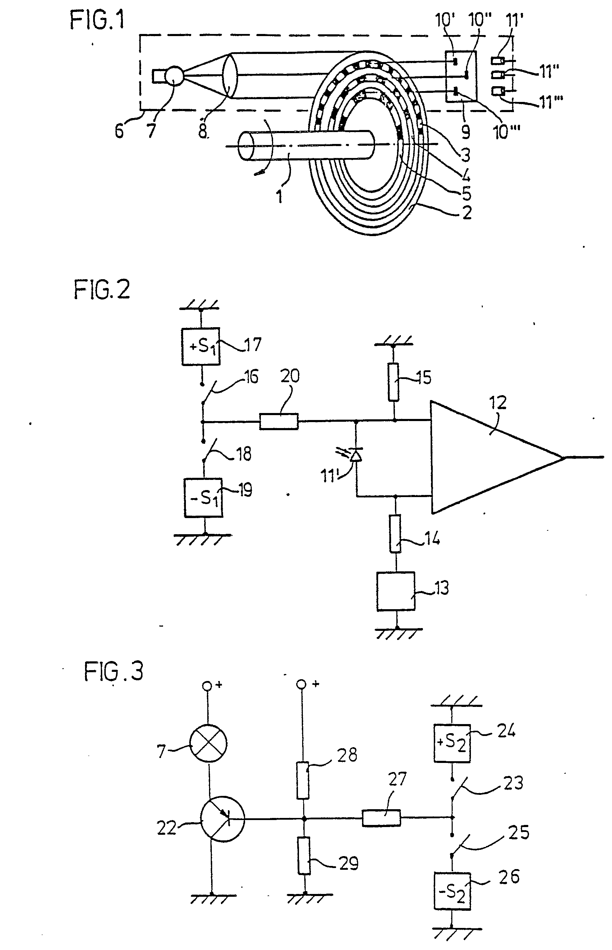

Das in Figur 1 dargestellte absolute Winkelmeßsystem weist eine von einer Geberwelle 1 angetriebene Maßverkörperung 2 in Form einer transparenten Scheibe auf, auf der eine inkrementale Teilung 3 (Feinspur) und zwei kodierte Teilungen 4, 5 (Grobspuren) konzentrisch angeordnet sind. Eine Abtasteinrichtung 6 weist eine Lampe 7, einen Kondensor 8, eine Abtastplatte 9 mit einem Abtastfeld 10' für die inkrementale Teilung 3 und Abtastfeldern 10", 10''' für die kodierten Teilungen 4, 5 sowie den Abtastfeldern 10', 10", 10''' zugeordnete Photodioden 11', 11", 11''' auf.

Gemäß Figur 2 ist die Photodiode 11' an die beiden Eingänge einer Triggerstufe 12 zur Auswertung ihres Ausgangssignals angeschlossen. Die Triggerschwelle der Triggerstufe 12 wird zur exakten Triggerung dieses Ausgangssignals mittels einer Spannungsquelle 13 eingestellt, die über einen Widerstand 14 an einem Eingang der Triggerstufe 12 angeschlossen ist. Durch einen Widerstand 15 wird im Zusammenwirken mit dem Widerstand 14 der Arbeitsbereich der Triggerstufe 12 festgelegt. Mittels eines extern steuerbaren Schalters 16 kann erfindungsgemäß von einer Gleichspannungsquelle 17 ein externes Prüfsignal $+S_1$ und mittels eines extern steuerbaren Schalters 18 von einer Gleichspannungssquelle 19 ein externes Prüfsignal $-S_1$ über einen Widerstand 20 dem anderen Eingang der Triggerstufe 12 zugeführt werden.

Zur Überprüfung der Lage der Triggerschwelle wird durch Anlegen des Prüfsignals $+S_1$ die Triggerschwelle angehoben und durch Anlegen des Prüfsignals $-S_1$ entsprechend abgesenkt. Ein fehlerhaftes Schalten der Triggerstufe 12 in diesem Prüfbereich kann durch fehlende Positionen auf der digitalen Positionsanzeige des Meßsystems erkannt werden. Die Größe der Prüfsignale $\pm S_1$ kann durch nicht gezeigte Mittel variiert werden, so daß sich unterschiedliche Prüfbereiche ergeben; vorzugsweise wird ein Grobprüfbereich und ein Feinprüfbereich vorgeschlagen. Die Überprüfung der Lage der Triggerschwelle der Triggerstufe 12 für die inkrementale Teilung 3 erfolgt bei der Bewegung des Meßsystems.

Die Photodioden 11″, 11‴ für die kodierten Teilungen 4, 5 sind ebenfalls in gleicher Weise an die Eingänge nicht gezeigter Triggerstufen angeschlossen, denen gleichfalls die Prüfsignale $\pm S_1$ zur Überprüfung der Lage ihrer Triggerschwellen zugeführt werden. Ein fehlerhaftes Schalten der Triggerstufen im betreffenden Prüfbereich wird durch Positionsänderungen größer als ein Bit auf der digitalen Positionsanzeige angezeigt. Die Überprüfung der Lage der Triggerschwellen der Triggerstufen für die kodierten Teilungen 4, 5 erfolgt beim stationären Zustand des Meßsystems.

Das Einstellen der Triggerschwelle der Triggerstufe 12 kann auch durch ein Gleichlichtsignal erfolgen, das mittels eines separaten lichtempfindlichen Elements erzeugt wird. Zur Überprüfung dieser Einstellung wird das Prüfsignal $\pm S_1$ dem Gleichlichtsignal überlagert.

In weiterer Ausbildung der Erfindung gemäß Figur 3 ist die Lampe 7 mit einem Anschluß an eine positive Spannung und mit dem anderen Anschluß an den Emitter eines Transistors 22 angeschlossen, dessen Kollektor mit Masse verbunden ist. Die Basis des Transistors 22 kann mittels eines externen Schalters 23 mit einem externen Prüfsignal $+S_2$ aus einer Gleichspannungsquelle 24 und mittels eines externen Schalters 25 mit einem externen Prüfsignal $-S_2$ aus einer Gleichspannungsquelle 26 über einen Widerstand 27 beaufschlagt werden. Zwei Widerstände 28, 29 dienen zur Einstellung des Arbeitspunktes.

Durch Anlegen des Prüfsignals $+S_2$ wird die Helligkeit der Lampe 7 erhöht und durch Anlegen des Prüfsignals $-S_2$ entsprechend verringert. Die Größe der Prüfsignale $\pm S_2$ kann durch nicht gezeigte Mittel variiert werden, so daß sich unterschiedliche Prüfbereiche zur Überprüfung des einwandfreien Schaltverhaltens der Triggerstufen einstellen lassen. Bei Meßsystemen, die als Beleuchtungseinrichtung mehrere lichtemittierenden Dioden aufweisen, die unterschiedlich altern und daher eine unterschiedliche Helligkeit aufweisen, kann durch Anlegen des variablen Prüfsignals $-S_2$ festgestellt werden, ob die dadurch verminderte Helligkeit der Dioden in einem vorgewählten Sicherheitsbereich noch zum einwandfreien Schalten der Triggerstufen ausreicht, so daß lichtschwache Dioden rechtzeitig ausgewechselt werden können.

Die Überprüfung der Einstellung der Triggerschwellen kann manuell stattfinden oder kann automatisch in bestimmten Zeitabständen mittels eines Rechners erfolgen.

**Patentansprüche**

1. Digitale Längen- oder Winkelmeßeinrichtung mit einer Abtasteinheit (6) zur Abtastung einer Maßverkörperung (2) mit codierten Teilungen (4, 5) und/oder einer inkrementalen Teilung (3) und mit einer Auswerteeinrichtung mit Triggerstufen (12) mit jeweils vorgegebenen Triggerschwellen zur Auswertung der von der Abtasteinheit (6) gelieferten Abtastsignale sowie mit einer Positionsanzeigeeinheit, dadurch gekennzeichnet, daß zur Überprüfung der Einstellung der Triggerschwellen eine Prüfeinrichtung vorgesehen ist, mittels der der Eingang der Triggerstufen (12) mit wenigstens einem Prüfsignal $(S_1, S_2)$ zur Anhebung oder Absenkung der Triggerschwellen beaufschlagt ist, und daß die Prüfeinrichtung ein Auswertemittel in Form der Positionsanzeigeeinheit aufweist, das das Ausgangssignal der Triggerstufen (12) auf das Schaltverhalten der Triggerstufen (12) hin überprüft.

2. Meßeinrichtung nach Anspruch 1, dadurch gekennzeichnet, daß das Prüfsignal $(S_1)$ den Triggerstufen (12) über Schaltmittel (16, 18) zuführbar ist.

3. Meßeinrichtung nach Anspruch 1, dadurch gekennzeichnet, daß die Abtasteinheit (6) ein Beleuchtungseinrichtung (7) sowie wenigstens ein lichtempfindliches Element (11′) zur Lieferung der Abtastsignale aufweist und daß Schaltmittel (22, 23, 25) zur Beaufschlagung der Beleuchtungseinrichtung (7) mit dem Prüfsignal $(S_2)$ zwecks Helligkeitsänderung vorgesehen sind.

4. Meßeinrichtung nach den Ansprüchen 2 und 3, dadurch gekennzeichnet, daß zur Lieferung der Prüfsignale $(S_1, S_2)$ Gleichspannungsquellen (17, 19, 24, 26) vorgesehen sind.

5. Meßeinrichtung nach Anspruch 1, dadurch gekennzeichnet, daß die Prüfsignale $(S_1, S_2)$ verschiedene Werte annehmen können, die jeweils verschiedene Prüfbereiche für die Lage der Triggerschwellen definieren.

6. Meßeinrichtung nach Anspruch 5, dadurch gekennzeichnet, daß die Prüfsignale ($S_1$, $S_2$) bipolare Gleichspannungssignale sind.

7. Meßeinrichtung nach Anspruch 1, dadurch gekennzeichnet, daß die Überprüfung der Einstellung der Triggerschwellen manuell stattfindet oder automatisch in bestimmten Zeitabständen mittels eines Rechners erfolgt.

8. Meßeinrichtung nach Anspruch 1, dadurch gekennzeichnet, daß die Triggerschwellen der Triggerstufen (12) durch ein von einem separaten lichtempfindlichen Element erzeugtes Gleichsignal eingestellt sind, dem die Prüfsignale ($S_1$, $S_2$) überlagerbar sind.

**Revendications**

1. Dispositif numérique de mesure de longueursou d'angles comportant une unité de balayage (6) pour le balayage d'une échelle de mesure (2) à graduations codées (4, 5) et/ou à graduation incrémentielle (3) et un dispositif d'interprétation muni d'étages à bascule (12) à seuils de basculement respectifs prédéterminés pour l'interprétation des signaux délivrés par l'unité de balayage (6), ainsi qu'une unité d'affichage de position, caractérisé par le fait que pour la vérification du réglage des seuile de basculement, il est prévu un dispositif d'essai au moyen duquel l'entrée des étages à bascule (12) reçoit au moins un signal de contrôle ($S_1$, $S_2$) pour élever ou abaisser les seuils de basculement et que le dispositif d'essai comporte un moyen d'interprétation sous la forme de l'unité d'affichage de position qui vérifie le signal de sortie des étages à bascule (12) pour contrôler le faculté de commutation des étages à bascule (12).

2. Dispositif de mesure selon la revendication 1, caractérisé par le fait que le signal de contrôle ($S_1$) peut être appliqué aux étages à bascule (12) par l'intermédiaire de moyens de commutation (16, 18).

3. Dispositif de mesure selon la revendication 1, caractérisé par le fait que l'unité de balayage (6) comporte un dispositif d'éclairage (7) ainsi qu'au moins un élément photosensible (11') pour délivrer les signaux de balayage et qu'il est prévu des moyens de commutation (22, 23, 25) pour envoyer au dispositif d'eclairage (7) le signal de contrôle ($S_2$) en vue de modifier la luminosité.

4. Dispositif de mesure selon les revendications 2 et 3, caractérisé par le fait que pour la délivrance des signaux de contrôle ($S_1$, $S_2$), il est prévu des sources de tension continue (17, 19, 24, 26).

5. Dispositif de mesure selon la revendication 1, caractérisé par le fait que les signaux de contrôle ($S_1$, $S_2$) peuvent prendre différentes valeurs qui définnissent respectivement différentes zones de contrôle pour la position des seuils de basculement.

6. Dispositif de mesure selon la revendication 5, caractérisé par le fait que les signaux de contrôle ($S_1$, $S_2$) sont des signaux de tension continue bipolaires.

7. Dispositif de mesure selon la revendication 1, caractérisé par le fait que la vérification du réglage des seuils de basculement a lieu manuellement ou est effectuée automatiquement à des intervalles de temps déterminés au moyen d'un calculateur.

8. Dispositif de mesure selon la revendication 1, caractérisé par le fait que les seuils de basculement des étages à bascule (12) sont réglés par un signal d'égalité produit par un élément photosensible séparé et auquel peuvent être superposés les signaux de contrôle ($S_1$, $S_2$).

**Claims**

1. A digital length- or angle-measuring device comprising a scanning unit (b) for scanning an embodiment (2) of a measurement having coded graduations (4, 5) and/or an incremental graduation (3), and an evaluation device having triggering stages (12) having triggering thresholds, which are predetermined in each case, for evaluating the scanning signals supplied by the scanning unit (b), and a position-indicating unit, characterised in that for the purpose of checking the adjustment of the triggering thresholds, a checking device is provided by means of which at least one checking signal ($S_1$, $S_2$) for raising or lowering the triggering thresholds is applied to the input of the triggering stages (12) and that the checking device has an evaluating means in the form of the position-indicating unit, which means checks the out-put signal of the triggering stages (12) for the switching behaviour of the triggering stages (12).

2. A measuring device according to Claim 1, characterised in that the checking signal ($S_1$) can be supplied to the triggering stages (12) via switching means (16, 18).

3. A measuring device according to Claim 1, characterised in that the scanning unit (b) is provided with an illuminating device (7) and at least one light-sensitive element (11') for supplying the scanning signals and that switching means (22, 23, 25) are provided for applying the checking signal ($S_2$) to the illuminating device (7) for the purpose of varying the brightness.

4. A measuring device according to Claims 2 and 3, characterised in that direct-voltage sources (17, 19, 24, 26) are provided for supplying the checking signals ($S_1$, $S_2$).

5. A measuring device according to Claim 1, characterised in that the checking signals ($S_1$, $S_2$) can assume various values which in each case define various checking ranges for the position of the triggering thresholds.

6. A measuring device according to Claim 5, characterised in that the checking signals ($S_1$, $S_2$) are bipolar direct-voltage signals.

7. A measuring device according to Claim 1, characterised in that the checking of the adjustment of the triggering thresholds is carried out manually or takes place automatically at certain time intervals by means of a computer.

8. A measuring device according to Claim 1, characterised in that the triggering thresholds of the triggering stages (12) can be adjusted by an equal-light signal which is generated by a separate light-sensitive element and on which the checking signals ($S_1$, $S_2$) can be superimposed.

FIG.1

FIG.2

FIG.3